# EUROPÄISCHE PATENTANMELDUNG

(11) **EP 0 939 354 A2**
(43) Veröffentlichungstag der Anmeldung: **01.09.1999**
(21) Anmeldenummer: 99103010.7
(22) Anmeldetag: 15.02.1999
(51) Int. Cl.: G05B 19/042, H05K 7/14

(54) **Vorrichtung zur Ansteuerung von Peripheriebaugruppen eines technischen Prozesses**

(30) Priorität: 27.02.1998 DE 19808343
(71) Anmelder: SIEMENS AKTIENGESELLSCHAFT, 80333 München (DE)
(72) Erfinder: Bergmann, Martin Dipl.-Ing. (FH), 92253 Schnaittenbach (DE)

(57) **Zusammenfassung**

Mit der vorliegenden Erfindung werden erstmalig Peripheriekanäle in die jeweiligen Anschlußleitungen integriert. Durch die Aufteilung der Peripheriebaugruppe in eine Ansteuerbaugruppe einerseits und E/A-Anschlußleitungen andererseits kann der Anwender seine Steuerung bedarfsgerecht einsetzen. Sind an der Peripheriebaugruppe noch freie Anschlußstellen zum Anschluß der Anschlußleitungen vorhanden, kann je nach Bedarf eine Anschlußleitung mit einem Peripheriekanal zur Realisierung der Funktionalität einer Digitaleingabe, einer Digitalausgabe, etc., angeschlossen werden. Ist auf der anderen Seite ein Kanal defekt, wird nur eine Anschlußleitung ausgetauscht, wobei die Baugruppe selbst unverändert montiert bleibt.

## Beschreibung

Die vorliegende Erfindung betrifft eine Vorrichtung zur Peripherieansteuerung.

Vorrichtungen zur Peripherieansteuerung, sog. Peripheriebaugruppen, sind z.B. aus der DE 196 165 51 bekannt. Derartige Peripheriebaugruppen weisen bisher eine feste Anzahl von Peripheriekanälen auf, wobei für jeden Peripheriekanal Anschlußmittel zum Kontaktieren von Ahschlußleitungen vorgesehen sind und die Anschlußleitungen an den Anschlußmitteln zur Verbindung externer Aktoren und/oder Sensoren mit der Baugruppe befestigt werden. Die Kanalzahl ist für jede Baugruppe fest vorgegeben und kann ggf. nur durch eine weitere Baugruppe erweitert werden, obwohl im ungünstigsten Fall z.B. nur ein zusätzlicher Kanal benötigt wird.

Die Aufgabe der vorliegenden Erfindung besteht daher darin, eine Vorrichtung zur Peripherieansteuerung anzugeben, bei der die Anzahl und insbesondere auch die Funktionalität zur Verfügung stehender Peripheriekanäle individuell und bedarfsgerecht anpaßbar ist.

Diese Aufgabe wird mit einer Vorrichtung zur Ansteuerung der Peripherie eines technischen Prozesses mit mindestens einem Peripheriekanal, Mitteln zur Ansteuerung des mindestens einen Peripheriekanals und Mitteln zum Verbinden der Peripherie mit der Vorrichtung dadurch gelost, daß der Peripheriekanal in die Mittel zum Verbinden der Peripherie mit der Vorrichtung integriert ist.

Wenn die Mittel zum Verbinden bei denen es sich üblicherweise um Ahschlußleitungen handelt, einen Steckverbinder aufweisen und der Peripheriekanal bzw. die elektronischen Bauteile zur Realisierung der Funktionalität eines Peripheriekanals in den Steckverbinder integriert ist, kann die mechanische Stabilität des Steckverbinders zum Schutz der elektronischen Komponenten des Peripheriekanals genutzt werden.

Wenn die Mittel zum Verbinden darüber hinaus eine Signalzustandsanzeige aufweisen, kann eine entsprechende Signalzustandsanzeige auf der Vorrichtung zur Peripherieansteuerung entfallen, wobei eine Signalzustandsanzeige auf der Vorrichtung selbst ohnehin nur bedingt realisierbar ist, da sich die Eigenschaften des Peripheriekanals erst mit dem Anschließen der Mittel zum Verbinden der Peripherie mit der Ansteuerungsvorrichtung ergeben.

Gleichwohl ist eine Signalzustandsanzeige, z.B. eine optische Signalzustandsanzeige, wünschenswert, so daß diese vorteilshaft in die Mittel zum Verbinden der Peripherie mit der Peripherieansteuerungsvorrichtung integriert ist.

Wenn ferner Mittel zur Konfiguration des Peripheriekanals vorgesehen sind, ist die Funktionalität des jeweiligen Peripheriekanals entsprechend einer jeweiligen Konfiguration vorgebbar. Die Funktionalität verschiedenartiger Peripheriekanälen umfaßt z.B. die digitale Eingabe, die digitale Ausgabe, die analoge Eingabe und die analoge Ausgabe.

Weitere Merkmale, Vorteile und Anwendungsmöglichkeiten der vorliegenden Erfindung ergeben sich aus den Unteransprüchen, der nachfolgenden Beschreibung eines Ausführungsbeispiels anhand der Zeichnung und der Zeichnung selbst. Dabei bilden alle beschriebenen und/oder bildlich dargestellten Merkmale für sich oder in beliebiger Kombination den Gegenstand der vorliegenden Erfindung, unabhängig von ihrer Zusammenfassung in den Patentansprüchen oder deren Rückbeziehung.

Dabei zeigt:

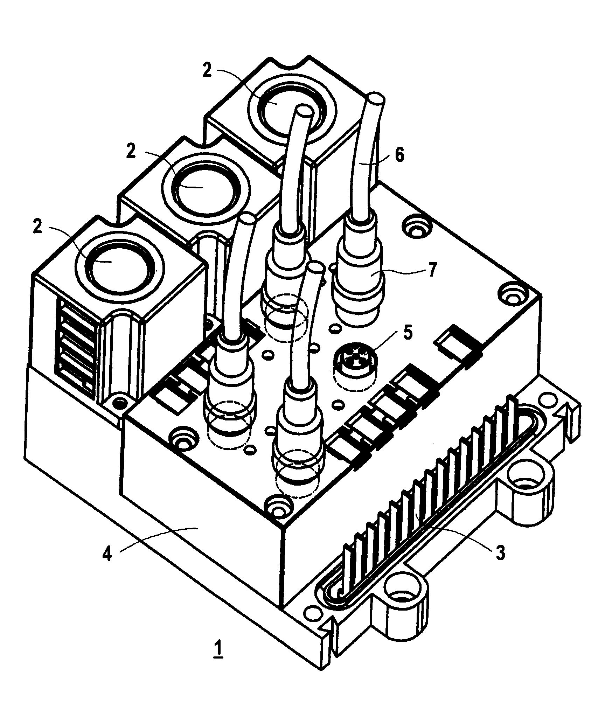

- FIG 1: eine Vorrichtung zur Peripherieansteuerung.

FIG 1 zeigt eine Vorrichtung zur Ahsteuerung der Peripherie eines technischen Prozesses. Diese Peripherieansteuerung 1 weist Mittel 2 zur Spannungsversorgung und zur elektrisch leitenden Verbindung mit einem Feldbus, z.B. dem Profibus, auf. Der Bus ist durch die Vorrichtung 1 hindurchgeschleift, so daß die Vorrichtung 1 in der in der DE 196 165 51 gezeigten Weise ggf. erweiterbar ist. Zum Anschluß von Erweiterungskomponenten sind die Kontaktmittel 3 herausgeführt. Mit der Vorrichtung 1 ist eine an den Bus angeschlossene Ansteuerbaugruppe 4 verbunden, die intern eine Buselektronik zur Interpretation der über den Bus übermittelten Daten aufweist. Die Ansteuerbaugruppe 4 weist Anschlußstellen 5 auf, wobei einige dieser Anschlußstellen 5 mit E/A-Anschlußleitungen 6 kontaktiert sind. Die E/A-Anschlußleitungen 6 stellen für das Ausführungsbeispiel die Mittel 6 zum Verbinden der Peripherie mit der Vorrichtung dar. Zum Kontaktieren der E/A-Anschlußleitungen 6 mit den Anschlußstellen 5 weisen die E/A-Anschlußleitungen 6 an ihrem Ende einen Steckverbinder 7 auf. Gemäß dem Ausführungsbeispiel ist in den Steckverbinder 7 der Peripheriekanal bzw. die elektronischen Bauteile, mit denen die jeweilige Funktionalität des Peripheriekanals realisiert ist, integriert. Die in den Steckverbinder 7 integrierten elektronischen Bauelemente realisieren dabei z.B. die Funktionalität einer Digitalausgabe, die Funktionalität einer Digitalausgabe, oder aber die Funktionalität einer Analogeingabe bzw. einer Analogausgabe. Dem Anwender stehen also an der Ansteuerbaugruppe 4 eine durch die konstruktive Ausgestaltung der Ansteuerbaugruppe 4 vorgegebene Anzahl von Anschlußstellen 5 zur Verfügung, wobei jede dieser Anschlußstellen mit einer entsprechend den jeweiligen Anforderungen wählbaren Anschlußleitung 6 verbindbar ist.

Bei den im Stand der Technik bekannten Peripheriebaugruppen war für jede Anschlußstelle durch die entsprechende interne Verdrahtung der Ansteuerbaugruppe 4 die jeweilige Funktionalität (Digitaleingabe, Digitalausgabe, Analogeingabe, Analogausgabe) fest vorgegeben. Wenn entsprechend der Erfindung der Peripheriekanal in die E/A-Anschlußleitungen 6 integriert ist, kann der Anwender die Anschlußstellen 5 entsprechend der jeweiligen Erfordernisse nutzen. Bei z.B. acht zur Verfügung stehenden Anschlußstellen 5 können z.B. drei der Anschlußstellen 5 mit E/A-Anschlußleitungen 6 zur Realisierung der Funktionalität einer Digitaleingabe, vier Anschlußstellen mit E/A-Anschlußleitungen 6 zur Realisierung der Funktionalität einer Digitalausgabe und die verbleibende Anschlußstelle 5 mit einer E/A-Anschlußleitung zur Realisierung der Funktionalität einer Analogausgabe verbunden werden.

Damit realisiert die Ansteuerbaugruppe 4 in Verbindung mit den jeweiligen E/A-Anschlußleitungen 6 eine erheblich größere Flexibilität hinsichtlich der jeweiligen Anschlußmöglichkeiten.

Die Vorrichtung 1 kann ggf. mit weiteren Ansteuerbaugruppen 4 erweitert werden, wobei dies aufgrund der Flexibilität, die eine einzelne Baugruppe 4 bietet, nur dann erforderlich ist, wenn die Anzahl der benötigten Kanäle die Anzahl der zur Verfügung stehenden Anschlußstellen 5 übersteigt.

Im Stand der Technik war es dagegen häufig so, daß eine erste Ansteuerbaugruppe 4 mit Digitaleingabefunktionalität, eine zweite Ansteuerbaugruppe 4 mit Digitalausgabefunktionalität und weitere Baugruppen vorzusehen waren, wobei bei jeder einzelnen Ansteuerbaugruppe nur wenige Anschlußstellen belegt waren.

Die elektronischen Bauteile für die jeweiligen Kanäle werden zusammen mit Signalzustandsanzeigen in den Steckverbindern 7 der Anschlußleitungen 6 integriert, wobei sowohl umspritzteals auch frei konfektionierbare Steckverbinder möglich sind. Die Steckverbinder können als Rund- oder Rechtecksteckverbinder ausgeführt werden. Die Parametrierung der Kanäle erfolgt über verschiedene, fest eingebrachte Brücken in der Steckverbindung. Die jeweiligen Kanäle sind somit frei konfigurierbar und können bedarfsgerecht an die jeweilige Ansteuerbaugruppe 4 angeschlossen werden.

Ansteuerbaugruppe 4 und E/A-Anschlußleitungen mit den daran vorgesehenen Steckverbindern 7 sind insbesondere so ausführbar, daß sie einer höheren Schutzart, z.B. IP 65, genügen.

Zusammenfassend läßt sich die vorliegende Erfindung wie folgt kurz darstellen:

Mit der vorliegenden Erfindung werden erstmalig Peripheriekanäle in die jeweiligen Anschlußleitungen integriert. Durch die Aufteilung der Peripheriebaugruppe in eine Ansteuerbaugruppe einerseits und E/A-Anschlußleitungen andererseits kann der Anwender seine Steuerung bedarfsgerecht einsetzen. Sind an der Peripheriebaugruppe noch freie Anschlußstellen zum Anschluß der Anschlußleitungen vorhanden, kann je nach Bedarf eine Anschlußleitung mit einem Peripheriekanal zur Realisierung der Funktionalität einer Digitaleingabe, einer Digitalausgabe, etc., angeschlossen werden.

Ist auf der anderen Seite ein Kanal defekt, wird nur eine Anschlußleitung ausgetauscht, wobei die Baugruppe selbst unverändert montiert bleibt.

## Patentansprüche

1. Vorrichtung zur Ansteuerung der Peripherie eines technischen Prozesses mit mindestens einem Peripheriekanal, Mitteln (2) zur Ansteuerung des mindestens einen Peripheriekanals (7) und Mitteln (2) zum Verbinden der Peripherie mit der Vorrichtung, **dadurch gekennzeichnet,** daß der Peripheriekanal in die Mittel (2) zum Verbinden der Peripherie mit der Vorrichtung (1) integriert ist.

2. Vorrichtung nach Anspruch 1, **dadurch gekennzeichnet,** daß die Mittel (2) zum Verbinden einen Steckverbinder (7) aufweisen und daß der Peripheriekanal in dem Steckverbinder (7) integriert ist.

3. Vorrichtung nach Anspruch 1 oder 2, , **dadurch gekennzeichnet,** daß die Mittel (2) zum Verbinden eine Signalzustandsanzeige aufweisen.

4. Vorrichtung nach Anspruch 1, 2 oder 3, , **dadurch gekennzeichnet,** daß Mittel (2) zur Konfiguration des Peripheriekanals vorgesehen sind.
